# EUROPEAN PATENT APPLICATION

(11) **EP 4 790 749 A1**
(43) Date of publication of application: **12.08.2026**
(21) Application number: 23958378.4
(22) Date of filing: 07.11.2023
(51) Int. Cl.: H01L 25/075, H10D 86/00, H10H 20/857, H10H 20/854

(54) **SUBSTRATE FOR TRANSFERRING SEMICONDUCTOR LIGHT-EMITTING ELEMENT FOR DISPLAY PIXEL AND DISPLAY DEVICE INCLUDING SEMICONDUCTOR LIGHT-EMITTING ELEMENT**

(71) Applicant: LG Electronics Inc., Yeongdeungpo-gu Seoul 07336 (KR)
(72) Inventor: KIM, Youngdo, Seoul 06772 (KR); YANG, Dohwan, Seoul 06772 (KR); LEE, Kyungdong, Seoul 06772 (KR); CHOI, Jinhyeok, Seoul 06772 (KR)
(74) Representative: Vossius & Partner Patentanwälte Rechtsanwälte mbB
(86) International application number: PCT/KR2023/017784
(87) International publication number: WO 2025/100577

(57) **Abstract**

A transfer substrate for a semiconductor light-emitting device for a display pixel according to an embodiment includes a substrate, a plurality of assembly wirings disposed on the substrate, an insulating layer disposed on the plurality of assembly wirings, and an organic layer disposed on the insulating layer and including an assembly hole in which a semiconductor light-emitting device is assembled, wherein the insulating layer includes a first region, and the first region may have a lower height than the organic layer.

## Description

### [Technical Field]

An embodiment relates to a transfer substrate for a semiconductor light-emitting device for a display pixel and a display device including the semiconductor light-emitting device.

### [Background Art]

Large-area displays include a liquid crystal display (LCD), an OLED display, and a micro-LED display.

The micro-LED display is a display using, as a display element, a micro-LED, which is a semiconductor light-emitting device having a diameter or cross-sectional area of 100 µm or less.

Since the micro-LED display uses the micro-LED, which is a semiconductor light-emitting device, as a display element, it has excellent performance in many characteristics such as contrast ratio, response speed, color reproducibility, viewing angle, brightness, resolution, lifetime, luminous efficiency, and luminance.

In particular, the micro-LED display has advantages in that a screen can be separated and combined in a modular manner so that size or resolution can be freely adjusted, and that a flexible display can be implemented.

However, since a large micro-LED display requires millions or more micro-LEDs, there is a technical problem in that it is difficult to rapidly and accurately transfer the micro-LEDs onto a display panel.

Recently developed transfer technologies include a pick-and-place process, a laser lift-off method, or a self-assembly method.

Among these, the self-assembly method is a method in which a semiconductor light-emitting device finds an assembly position by itself in a fluid, and is advantageous for implementing a large-area display device.

Recently, U.S. Patent No. 9,825,202 has proposed a micro-LED structure suitable for self-assembly, but research on a technology for manufacturing a display through self-assembly of micro-LEDs is still insufficient.

In particular, in the related art, when millions or more semiconductor light-emitting devices are rapidly transferred to a large display, the transfer speed may be improved, but a transfer error rate may increase, thereby causing a technical problem in that a transfer yield is lowered.

Meanwhile, in the related art, a transfer process of a self-assembly method using dielectrophoresis (DEP) has been attempted, but there is a problem in that an assembly rate is low due to non-uniformity of DEP force.

Meanwhile, in manufacturing a large-area display panel, when a stamp process is repeatedly performed, there is a difficulty in manufacturing a high PPI display panel due to protrusions of a stamp in an overlapping region.

### [Mode for Invention]

### [Technical Problem]

One of the technical problems of an embodiment is to implement a high PPI display panel.

Another of the technical problems of an embodiment is to implement a large-area display panel.

Another of the technical problems of an embodiment is to pick up a semiconductor light-emitting device assembled on an assembly substrate in a state in which a semiconductor light-emitting device is picked up by a stamp during a transfer process.

Another of the technical problems of an embodiment is to improve heat dissipation performance of a semiconductor light-emitting device and a thin film transistor.

Another of the technical problems of an embodiment is to make a transfer rate uniform regardless of a region of a stamp during a transfer process.

Another of the technical problems of an embodiment is to improve light efficiency in a display device.

The technical problems of the embodiment are not limited to those described in this section and include those that can be understood from the description of the invention.

### [Technical Solution]

A transfer substrate for a semiconductor light-emitting device for a display pixel according to an embodiment includes a substrate; a plurality of assembly wirings disposed on the substrate; an insulating layer disposed on the plurality of assembly wirings; and an organic layer disposed on the insulating layer and having an assembly hole in which a semiconductor light-emitting device is assembled, wherein the insulating layer includes a first region, and the first region may have a lower height than the organic layer.

In addition, a transfer substrate for a semiconductor light-emitting device for a display pixel according to an embodiment includes a substrate; an insulating layer disposed on the substrate; a plurality of organic layers disposed on the insulating layer to be spaced apart from each other; a plurality of panel electrodes disposed on the organic layers; and a second insulating layer disposed on the plurality of panel electrodes, wherein a trench may be included between the plurality of organic layers.

In addition, in an embodiment, the insulating layer includes a first region outside the organic layer, and the first region may have a lower height than the organic layer.

In addition, in an embodiment, the panel electrodes include a first assembly hole in which a first semiconductor light-emitting device is assembled and a second assembly hole in which a second semiconductor light-emitting device is assembled, and the second semiconductor light-emitting device may be a redundant chip of the first semiconductor light-emitting device.

In addition, in an embodiment, the organic layer may be surrounded by the first region.

In addition, a display device including a semiconductor light-emitting device according to an embodiment includes a substrate; an insulating layer disposed on the substrate; a plurality of organic layers disposed on the insulating layer to be spaced apart from each other; panel wirings disposed on the organic layers; an adhesive layer disposed on the panel wirings; and a semiconductor light-emitting device disposed on the adhesive layer, wherein the semiconductor light-emitting device is electrically connected to the panel wirings through a side wiring, and a trench may be included between the plurality of organic layers.

In addition, in an embodiment, the adhesive layer may have different heights in a region vertically overlapping the organic layer and a region vertically overlapping the trench.

In addition, in an embodiment, a planarization layer covering the adhesive layer is further included, and the planarization layer may be disposed to correspond to a shape of the adhesive layer.

In addition, in an embodiment, the adhesive layer may further include a light control material.

In addition, in an embodiment, a second region may be further included on the trench, and the second region may be positioned lower than the semiconductor light-emitting device.

### [Advantageous Effects]

A transfer substrate for a semiconductor light-emitting device for a display pixel according to an embodiment can provide a technical effect of implementing a high PPI display panel.

For example, the embodiment can provide a separate region in which bubbles are trapped during a transfer process, and a flat stamp can be used in the transfer process, thereby enabling implementation of a high PPI display panel.

In addition, the embodiment can provide a technical effect of implementing a large-area display panel.

For example, the embodiment can provide a separate region in which bubbles are trapped during a transfer process, and a flat stamp can be used in the transfer process, thereby preventing transfer defects in a region where stamping overlaps, so that a large-area display panel can be implemented.

In addition, the embodiment can provide a technical effect of making a transfer rate uniform regardless of a region of a stamp.

For example, the embodiment can use a flat stamp without protrusions, thereby making the transfer rate uniform regardless of a central region and an outer region.

In addition, the embodiment can provide a technical effect of improving heat dissipation performance of a display device.

For example, in the embodiment, a semiconductor light-emitting device may be disposed on an organic layer, and a distance from a thin film transistor may increase, so that heat dissipation performance can be improved.

In addition, the embodiment can provide a technical effect of improving light efficiency of a display device.

For example, in the embodiment, a light control material may be added to an adhesive layer, and light efficiency of the display device can be improved through light reflection and scattering.

In addition, the embodiment can provide a technical effect of picking up a semiconductor light-emitting device assembled on an assembly substrate in a state in which a semiconductor light-emitting device is picked up by a stamp during a transfer process.

For example, in the embodiment, the semiconductor light-emitting device picked up by the stamp may be positioned on a first region, and the semiconductor light-emitting device assembled may be picked up by the stamp, thereby enabling multi pick-up and placement.

The technical effects of the embodiment are not limited to those described in this section and include those that can be understood from the description of the invention.

### [Description of Drawings]

FIG. 1 is a view illustrating a living room of a house in which a display device according to an embodiment is disposed.
FIG. 2 is an enlarged view of a first panel region in the display device of FIG. 1.
FIG. 3 is a cross-sectional view taken along line B1-B2 of region A2 of FIG. 2.
FIG. 4 is a view illustrating an example in which a light-emitting device is assembled on a substrate by a self-assembly method according to an embodiment.
FIG. 5 is a plan view of a transfer substrate for a semiconductor light-emitting device for a display pixel according to a first embodiment.
FIG. 6 is a cross-sectional view taken along line AA' of FIG. 5.
FIG. 7 is a conceptual view of a transfer substrate for a semiconductor light-emitting device for a display pixel according to a second embodiment.
FIG. 8 is a conceptual view of a transfer substrate for a semiconductor light-emitting device for a display pixel according to a third embodiment.
FIG. 9 is a conceptual view of a transfer substrate for a semiconductor light-emitting device for a display pixel according to a fourth embodiment.
FIG. 10 is a conceptual view of a transfer substrate for a semiconductor light-emitting device for a display pixel according to a fifth embodiment.
FIGS. 11 and 12 are conceptual views of a display device including a semiconductor light-emitting device according to a sixth embodiment.
FIG. 13 is a conceptual view of a transfer donor for a semiconductor light-emitting device according to a seventh embodiment.

### [Mode for Invention]

Hereinafter, embodiments disclosed in the present specification will be described in detail with reference to the accompanying drawings. In the following description, suffixes such as "module" and "unit" for components are assigned or used interchangeably in consideration of convenience in preparing the specification, and do not have meanings or roles distinguished from each other by themselves. In addition, the accompanying drawings are provided to facilitate understanding of the embodiments disclosed in the present specification, and the technical idea disclosed in the present specification is not limited by the accompanying drawings. In addition, when an element such as a layer, a region, or a substrate is referred to as being on another element, it includes not only a case in which the element is directly on another element but also a case in which another intermediate element is present therebetween.

The display device described in the present specification may include a digital TV, a mobile phone, a smart phone, a laptop computer, a digital broadcasting terminal, a PDA, a PMP, a navigation device, a slate PC, a tablet PC, an ultrabook, and a desktop computer. However, the configuration according to the embodiment described in the present specification can be applied to a device capable of displaying even if it is a newly developed product type.

Hereinafter, a light-emitting device according to an embodiment and a display device including the same will be described.

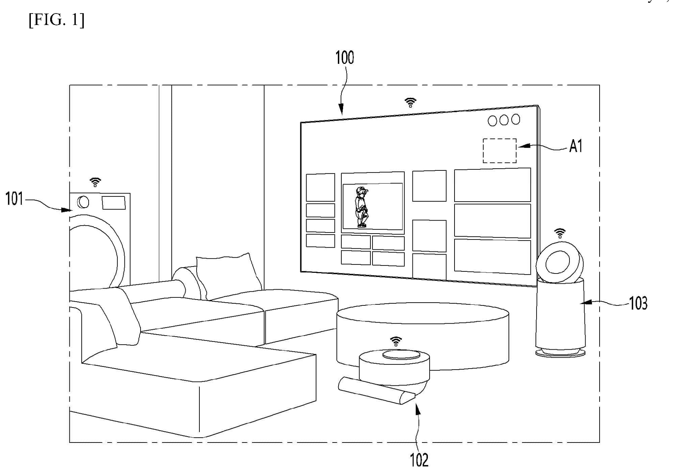

FIG. 1 illustrates a living room of a house in which a display device 100 according to an embodiment is disposed.

The display device 100 according to the embodiment can display states of various electronic products such as a washing machine 101, a robot cleaner 102, and an air purifier 103, can communicate with each electronic product based on IoT, and can control each electronic product based on user setting data.

The display device 100 according to the embodiment may include a flexible display fabricated on a thin and flexible substrate. The flexible display can be bent or rolled like paper while maintaining characteristics of a conventional flat display.

In the flexible display, visual information can be implemented by independently controlling light emission of unit pixels arranged in a matrix form. The unit pixel means a minimum unit for implementing one color. The unit pixel of the flexible display may be implemented by a light-emitting device. In an embodiment, the light-emitting device may be a micro-LED or a nano-LED, but is not limited thereto.

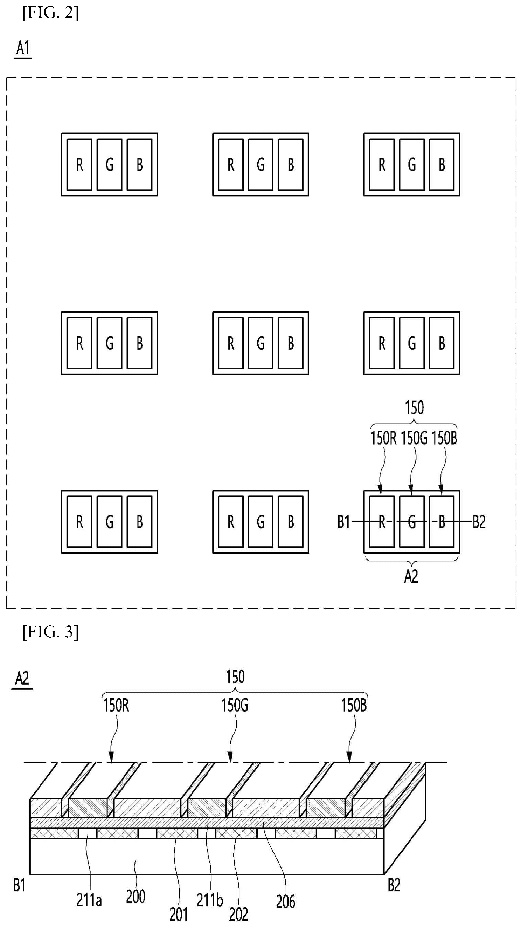

FIG. 2 is an enlarged view of a first panel region A1 in the display device of FIG. 1.

Referring to FIG. 2, the display device 100 according to the embodiment may be manufactured by mechanically and electrically connecting a plurality of panel regions such as the first panel region A1 by tiling.

The first panel region A1 may include a plurality of light-emitting devices 150 arranged for each unit pixel PX.

For example, the unit pixel PX may include a first sub-pixel PX1, a second sub-pixel PX2, and a third sub-pixel PX3. For example, a plurality of red light-emitting devices 150R may be disposed in the first sub-pixel PX1, a plurality of green light-emitting devices 150G may be disposed in the second sub-pixel PX2, and a plurality of blue light-emitting devices 150B may be disposed in the third sub-pixel PX3. The unit pixel PX may further include a fourth sub-pixel in which no light-emitting device is disposed, but is not limited thereto. Meanwhile, the light-emitting device 150 may be a semiconductor light-emitting device.

Next, FIG. 3 is a cross-sectional view taken along line B1-B2 of region A2 of FIG. 2.

Referring to FIG. 3, the display device 100 according to the embodiment may include a substrate 200, assembly wirings 201 and 202, a first insulating layer 211a, a second insulating layer 211b, a third insulating layer 206, and a plurality of light-emitting devices 150.

The assembly wiring may include a first assembly wiring 201 and a second assembly wiring 202 spaced apart from each other. The first assembly wiring 201 and the second assembly wiring 202 may be provided to generate a dielectrophoresis force in order to assemble the light-emitting device 150. In addition, the first assembly wiring 201 and the second assembly wiring 202 may be electrically connected to electrodes of the light-emitting device and may function as electrodes of a display panel.

The assembly wirings 201 and 202 may be formed of a transparent electrode (ITO) or may include a metal material having excellent electrical conductivity. For example, the assembly wirings 201 and 202 may be formed of at least one selected from titanium (Ti), chromium (Cr), nickel (Ni), aluminum (Al), platinum (Pt), gold (Au), tungsten (W), and molybdenum (Mo), or alloys thereof.

A first insulating layer 211a may be disposed between the first assembly wiring 201 and the second assembly wiring 202, and a second insulating layer 211b may be disposed on the first assembly wiring 201 and the second assembly wiring 202. The first insulating layer 211a and the second insulating layer 211b may be an oxide layer or a nitride layer, but are not limited thereto.

The light-emitting device 150 may include a red light-emitting device 150, a green light-emitting device 150G, and a blue light-emitting device 150B to form each unit pixel (sub-pixel), but is not limited thereto, and red and green may be implemented by including a red phosphor and a green phosphor, respectively.

The substrate 200 may be formed of glass or polyimide. In addition, the substrate 200 may include a flexible material such as polyethylene naphthalate (PEN) or polyethylene terephthalate (PET). In addition, the substrate 200 may be a light-transmissive material, but is not limited thereto.

The third insulating layer 206 may include an insulating and flexible material such as polyimide, PEN, or PET, and may be formed integrally with the substrate 200 to form one substrate.

The third insulating layer 206 may be a conductive adhesive layer having adhesion and conductivity, and the conductive adhesive layer may have flexibility to enable a flexible function of the display device. For example, the third insulating layer 206 may be an anisotropic conductive film (ACF) or a conductive adhesive layer such as an anisotropic conductive medium or a solution including conductive particles. The conductive adhesive layer may be a layer that is electrically conductive in a vertical direction with respect to a thickness, but electrically insulating in a horizontal direction with respect to the thickness.

The third insulating layer 206 may include an assembly hole 203 into which the light-emitting device 150 is inserted. Accordingly, during self-assembly, the light-emitting device 150 may be easily inserted into the assembly hole 203 of the third insulating layer 206. The assembly hole 203 may be referred to as an insertion hole, a fixing hole, or an alignment hole.

A distance between the assembly wirings 201 and 202 may be formed to be smaller than a width of the light-emitting device 150 and a width of the assembly hole 203, so that an assembly position of the light-emitting device 150 using an electric field may be more precisely fixed.

The third insulating layer 206 may be formed on the assembly wirings 201 and 202 to protect the assembly wirings 201 and 202 from a fluid 1200 and to prevent leakage of current flowing through the assembly wirings 201 and 202. The third insulating layer 206 may be formed as a single layer or a multilayer including an inorganic insulator such as silica or alumina, or an organic insulator.

In addition, the third insulating layer 206 may include an insulating and flexible material such as polyimide, PEN, or PET, and may be formed integrally with the substrate 200 to form one substrate.

The third insulating layer 206 may be an insulating layer having adhesion or may be a conductive adhesive layer having conductivity. The third insulating layer 206 may have flexibility to enable a flexible function of the display device.

The third insulating layer 206 may include a partition wall, and the assembly hole 203 may be formed by the partition wall. For example, when the substrate 200 is formed, a portion of the third insulating layer 206 may be removed, so that each of the light-emitting devices 150 may be assembled in the assembly hole 203 of the third insulating layer 206.

The substrate 200 may have the assembly hole 203 to which the light-emitting devices 150 are coupled, and a surface on which the assembly hole 203 is formed may be in contact with the fluid 1200. The assembly hole 203 may guide an accurate assembly position of the light-emitting device 150.

Meanwhile, the assembly hole 203 may have a shape and a size corresponding to a shape of the light-emitting device 150 to be assembled at a corresponding position. Accordingly, it is possible to prevent another light-emitting device from being assembled in the assembly hole 203 or a plurality of light-emitting devices from being assembled.

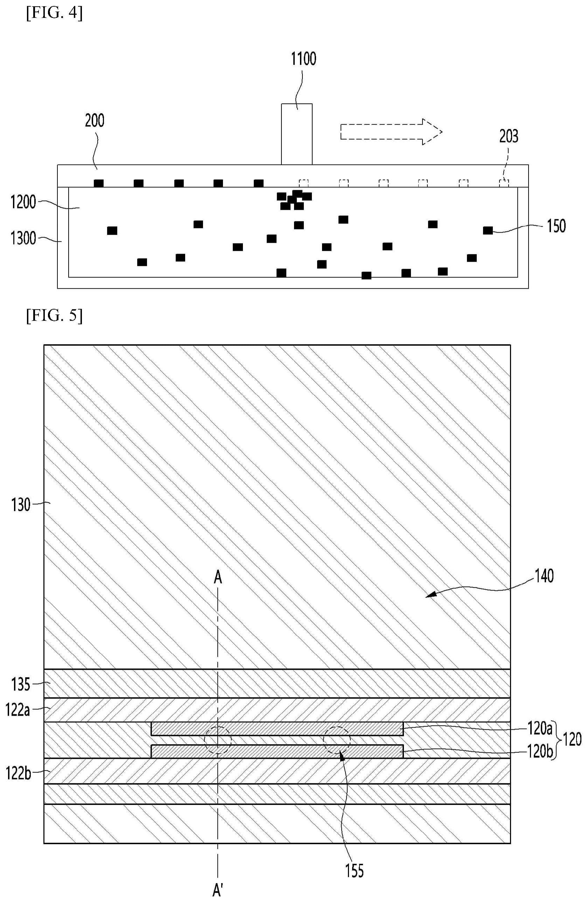

FIG. 4 is a view illustrating an example in which a light-emitting device is assembled on a substrate by a self-assembly method according to an embodiment, and a self-assembly method of the light-emitting device will be described with reference to the drawings.

The substrate 200 may be a panel substrate of a display device. In the following description, the substrate 200 is described as a case in which the substrate 200 is a panel substrate of a display device, but the embodiment is not limited thereto.

Referring to FIG. 4, a plurality of light-emitting devices 150 may be introduced into a chamber 1300 filled with a fluid 1200. The fluid 1200 may be water such as ultrapure water, but is not limited thereto. The chamber may be referred to as a tank, a container, or a vessel.

Thereafter, the substrate 200 may be disposed on the chamber 1300. According to an embodiment, the substrate 200 may be introduced into the chamber 1300.

As illustrated in FIG. 3, a pair of assembly wirings 201 and 202 corresponding to each of the light-emitting devices 150 to be assembled may be disposed on the substrate 200.

Referring to FIG. 4, after the substrate 200 is disposed, an assembly apparatus 1100 including a magnetic material may move along the substrate 200. For example, a magnet or an electromagnet may be used as the magnetic material. The assembly apparatus 1100 may move in contact with the substrate 200 to maximize a region in which a magnetic field affects the fluid 1200. According to an embodiment, the assembly apparatus 1100 may include a plurality of magnetic materials or may include a magnetic material having a size corresponding to the substrate 200. In this case, a movement distance of the assembly apparatus 1100 may be limited within a predetermined range.

By a magnetic field generated by the assembly apparatus 1100, the light-emitting devices 150 in the chamber 1300 may move toward the assembly apparatus 1100.

The light-emitting device 150 may enter the assembly hole 203 by a DEP force while moving toward the assembly apparatus 1100 and may be in contact with the substrate 200.

Specifically, the assembly wirings 201 and 202 may form an electric field by power supplied from the outside, and a dielectrophoresis force may be formed between the assembly wirings 201 and 202 by the electric field. By the dielectrophoresis force, the light-emitting device 150 may be fixed in the assembly hole 203 on the substrate 200.

By an electric field applied by the assembly wirings 201 and 202 formed on the substrate 200, the light-emitting device 150 in contact with the substrate 200 may be prevented from being detached due to movement of the assembly apparatus 1100. According to an embodiment, by the above-described self-assembly method using an electromagnetic field, a time required for each of the light-emitting devices 150 to be assembled on the substrate 200 can be significantly reduced, so that a large-area high-resolution display can be implemented more rapidly and economically.

At this time, a predetermined solder layer (not shown) may be formed between the light-emitting device 150 assembled on the assembly hole 203 of the substrate 200 and the assembly electrode, thereby improving a bonding force of the light-emitting device 150.

Next, a molding layer (not shown) may be formed in the assembly hole 203 of the substrate 200. The molding layer may be a light-transmissive resin or a resin including a reflective material or a scattering material.

FIG. 5 is a plan view of a transfer substrate for a semiconductor light-emitting device for a display pixel according to a first embodiment. Referring to FIG. 5, in the transfer substrate, an insulating layer 130 may be disposed on a substrate (not shown). Assembly wiring 120 may be connected to panel wirings 122a and 122b on the insulating layer 130, and assembly holes 155 may be disposed on a plurality of assembly wirings. The assembly holes 155 may include a plurality thereof, and a redundant chip may be assembled.

Meanwhile, an organic layer 135 may be disposed to vertically overlap the assembly wiring 120. The organic layer 135 may include the assembly hole 155 and may perform a function of a partition wall. The insulating layer 130 may include a first region 140 in which the organic layer 135 is not disposed.

Meanwhile, a height difference may exist between the organic layer 135 and the first region 140. Accordingly, when a stamp picks up a semiconductor light-emitting device from the transfer substrate during a pick-and-place transfer process, the stamp may not be in contact with the first region 140. Meanwhile, bubbles generated during the transfer process may be gathered in the first region 140. In addition, the bubbles may be discharged to the outside of the transfer substrate through the first region 140.

Meanwhile, in an internally developed technology, a transfer substrate for a semiconductor light-emitting device is formed such that an organic layer covers an entire insulating layer, and accordingly, when a stamp is used in a transfer process, a stamp having protrusions has been used in order to prevent a problem in which bubbles are trapped between the substrate and the stamp and the stamp is pushed.

However, in the stamp having protrusions, chips are positioned at edges of the protrusions, so that a transfer rate depending on positions is non-uniform, and a problem of transfer defects may occur. In addition, in manufacturing a large-area display panel, there has been a problem in that it is difficult to implement a high PPI display panel due to protrusions in an overlapping region when a stamp process is performed multiple times.

Meanwhile, in the embodiment, since bubbles are discharged to the outside of the transfer substrate through the first region 140, a flat stamp without protrusions may be used in a transfer process, and accordingly, it is possible to implement a high PPI display panel and a large-area display panel, and to provide a technical effect of making a transfer rate uniform depending on regions of the stamp.

In addition, in the embodiment, by positioning a semiconductor light-emitting device picked up by a stamp on the first region 140 during a pick-and-place process, it is possible to provide a special technical effect in which a semiconductor light-emitting device assembled on an assembly substrate can be additionally picked up in a state in which the semiconductor light-emitting device is picked up by the stamp.

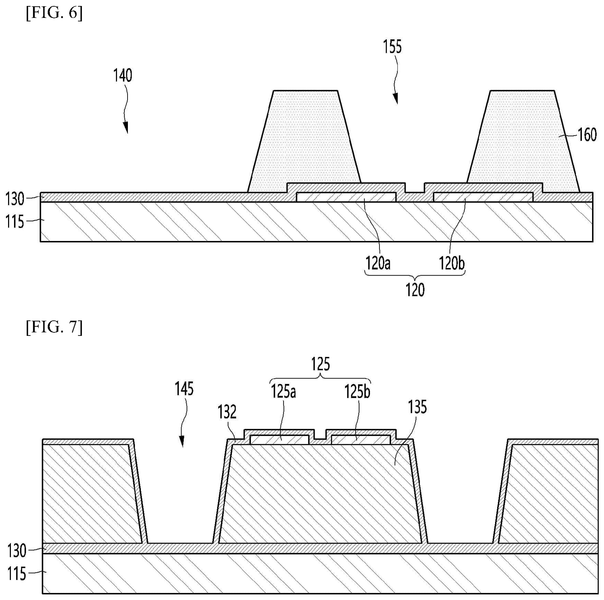

FIG. 6 is a cross-sectional view taken along line AA' of FIG. 5. Referring to FIG. 6, a plurality of assembly wirings 120 may be disposed on an assembly substrate 115. In addition, an insulating layer 130 may be disposed to cover the plurality of assembly wirings 120 and the assembly substrate 115. The insulating layer 130 may include an inorganic material. The insulating layer 130 may be referred to as an inorganic layer.

In addition, a partition wall 160 including an assembly hole 155 may be disposed on the plurality of assembly wirings 120. The partition wall 160 may include an organic material. The partition wall 160 may be referred to as an organic layer. A semiconductor light-emitting device may be assembled in the assembly hole 155. A height of the partition wall may be positioned lower than an upper surface of the semiconductor light-emitting device.

Meanwhile, in the first embodiment of FIG. 6, the partition wall 160 may be disposed in a region overlapping the assembly wiring 120, and may be a first region in which the partition wall is not disposed in a region where the assembly wiring 120 is not disposed. The first region 140 may be a region in which the organic layer is not disposed. In the first region 140, the insulating layer 130 may be exposed. The first region 140 may have a lower height than the partition wall 160.

In this case, the first region 140 may be used as a passage through which bubbles escape to an outside of the substrate during a transfer process using a PDMS stamp. Accordingly, in the embodiment, a PDMS stamp without protrusions may be used in the transfer process.

Therefore, in the embodiment, by using a flat PDMS stamp in the transfer process, a technical effect of implementing a high PPI display panel can be provided.

In addition, in the embodiment, by including the first region 140, a technical effect can be provided in which a semiconductor light-emitting device assembled on the assembly substrate 115 can be picked up in a state in which a semiconductor light-emitting device is picked up by a stamp.

FIG. 7 is a conceptual view of a transfer substrate for a semiconductor light-emitting device for a display pixel according to a second embodiment. Referring to FIG. 7, an insulating layer 130 may be disposed on a substrate 115. The insulating layer 130 may include an inorganic material. A plurality of organic layers 135 may be disposed on the insulating layer 130. The organic layers 135 may have a predetermined height. The organic layers 135 may include an organic material. Panel wirings 125 may be disposed on the organic layers 135. The panel wirings 125 may include a plurality thereof. The panel wirings 125 may include a first panel wiring 125a and a second panel wiring 125b. A second insulating layer 132 may be disposed to cover the panel wirings 125. The second insulating layer 132 may be connected to the insulating layer 130. In addition, a semiconductor light-emitting device (not shown) may be disposed on the panel wiring 125. The semiconductor light-emitting device may be electrically connected to the panel wiring 125.

Meanwhile, the substrate 115 may include a thin film transistor. In addition, as the organic layer 135 is disposed on the substrate and the semiconductor light-emitting device is disposed on the organic layer 135, a distance between the thin film transistor and the semiconductor light-emitting device may increase, so that heat dissipation performance can be improved.

In addition, the plurality of organic layers 135 may be disposed to be spaced apart from each other, and a trench 145 may be formed therebetween. Accordingly, during a transfer process of the semiconductor light-emitting device, bubbles generated as the substrate and a PDMS stamp adhere may be gathered in the trench 145, and the bubbles may be discharged to the outside of the substrate. Therefore, in the second embodiment, since the trench 145 prevents bubbles from being trapped in the substrate, a PDMS stamp without protrusions may be used in the transfer process, and a technical effect of implementing a high PPI transfer substrate can be provided.

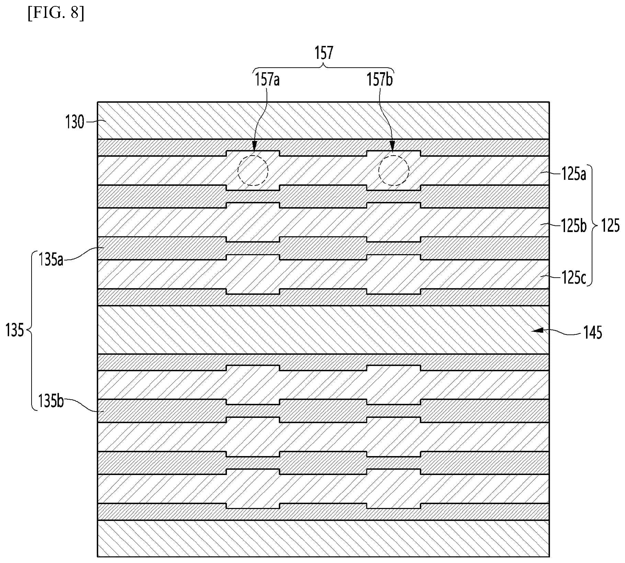

FIG. 8 is a conceptual view of a transfer substrate for a semiconductor light-emitting device according to a third embodiment. Referring to FIG. 8, an organic layer 135 may be disposed on an insulating layer 130.

A plurality of panel wirings 125 may be disposed on the organic layer 135. In addition, a semiconductor light-emitting device 157 may be disposed on each of the plurality of panel wirings 125. The semiconductor light-emitting device 157 may include a first-first semiconductor light-emitting device 157a and a first-second semiconductor light-emitting device 157b. The first-second semiconductor light-emitting device 157b may be a redundant chip of the first-first semiconductor light-emitting device 157a.

In addition, the plurality of panel wirings 125 may include a first panel wiring 125a, a second panel wiring 125b, and a third panel wiring 125c. Semiconductor light-emitting devices emitting different colors may be disposed on the first panel wiring 125a, the second panel wiring 125b, and the third panel wiring 125c.

The organic layer 135 may include a first organic layer 135a and a second organic layer 135b. The first organic layer 135a and the second organic layer 135b may be disposed to be spaced apart from each other. The first organic layer 135a and the second organic layer 135b may have a predetermined height. Accordingly, a region between the first organic layer 135a and the second organic layer 135b may be a trench 145. Although three panel wirings 125 are illustrated as being disposed on the first organic layer 135a in the drawing, the present disclosure is not limited thereto.

Accordingly, in the third embodiment, as the organic layers 135 on which the panel wirings 125 are disposed are spaced apart from each other, the trench 145 is formed, and during the transfer process, bubbles may be gathered in the trench and then discharged to the outside of the substrate.

Accordingly, in the third embodiment, during the transfer process, bubbles are gathered in the trench 145 and bubbles are prevented from being trapped in the substrate, so that a PDMS stamp without protrusions may be used in the transfer process, and a technical effect of implementing a high PPI transfer substrate can be provided.

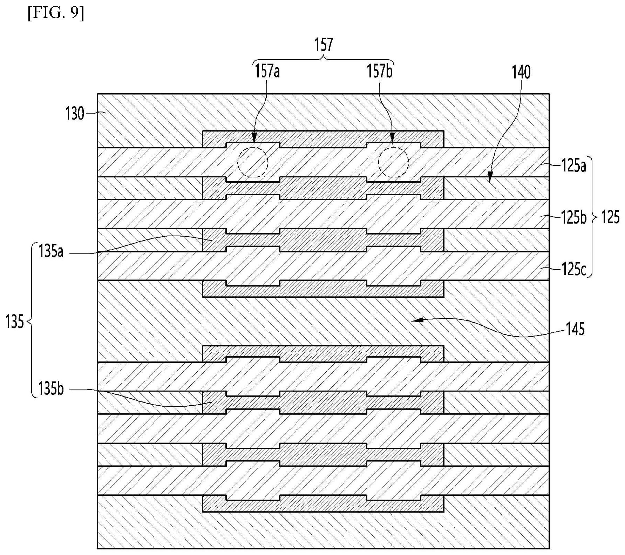

FIG. 9 is a conceptual view of a transfer substrate for a semiconductor light-emitting device according to a fourth embodiment. The fourth embodiment may adopt technical features of the third embodiment. For example, in the fourth embodiment, as a trench is formed between the first organic layer 135a and the second organic layer 135b, bubbles may be gathered in the trench 145 during the transfer process, and bubbles are prevented from being trapped in the substrate, so that a PDMS stamp without protrusions may be used in the transfer process, and a technical effect of implementing a high PPI transfer substrate can be provided. Referring to FIG. 9, in the fourth embodiment, the organic layer 135 may partially overlap the panel wiring 125. The insulating layer 130 may include a first region 140 in which the organic layer 135 is not disposed. The organic layer 135 and the first region 140 may have a height difference. The organic layer 135 may be surrounded by the first region 140 and the trench 145.

Accordingly, in the fourth embodiment, bubbles are trapped in the first region and the trench, so that a transfer process may be performed using a flat PDMS stamp, thereby enabling implementation of a high-resolution display device and preventing transfer defects caused by bubbles.

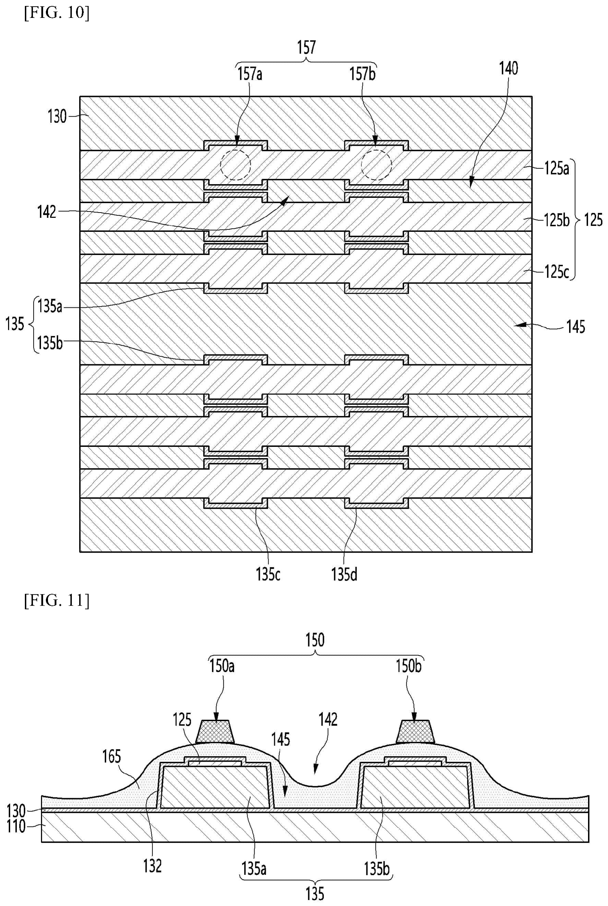

FIG. 10 is a conceptual view of a transfer substrate for a semiconductor light-emitting device according to a fifth embodiment. The fifth embodiment may adopt technical features of the fourth embodiment. For example, in the fifth embodiment, as a trench is formed between the first organic layer 135a and the second organic layer 135b and a first region 140 is formed at an outer side of the organic layers, bubbles may be gathered in the trench and the first region during the transfer process, and bubbles are prevented from being trapped in the substrate, so that a PDMS stamp without protrusions may be used in the transfer process, and a technical effect of implementing a high PPI transfer substrate can be provided. Referring to FIG. 10, an organic layer vertically overlapping one panel wiring 125 may include a plurality of organic layers, and the plurality of organic layers may include a third organic layer 135c and a fourth organic layer 135d spaced apart from each other.

A second region 142 may be disposed between the third organic layer 135c and the fourth organic layer 135d. The organic layer and the second region 142 may have a height difference. The second region 142 may correspond to a depth of the trench 145. Accordingly, each of the organic layers 135 may be surrounded by the first region 140, the second region 142, and the trench 145.

In addition, a first semiconductor light-emitting device 157a may be disposed on the third organic layer 135c, and a second semiconductor light-emitting device 157b may be disposed on the fourth organic layer 135d. The second semiconductor light-emitting device 157b may be a redundant chip of the first semiconductor light-emitting device 157a.

Accordingly, in the fifth embodiment, bubbles are trapped in the first region, the second region, and the trench, so that a transfer process may be performed using a flat PDMS stamp, thereby enabling implementation of a high-resolution display device and preventing transfer defects caused by bubbles.

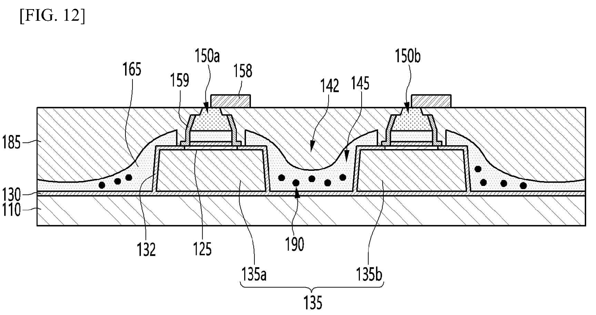

FIGS. 11 and 12 are conceptual views of a display device including a semiconductor light-emitting device according to a sixth embodiment. Referring to FIG. 11, an insulating layer 130 may be disposed on a substrate 110, an organic layer 135 may be disposed on the insulating layer 130, and panel wiring 125 may be disposed on the organic layer 135. In addition, a second insulating layer 132 may be disposed to cover the organic layer 135 and the panel wiring 125. In addition, an adhesive layer 165 may be disposed to cover the substrate 110 and the second insulating layer 132. A semiconductor light-emitting device 150 may be transferred onto the adhesive layer 165.

Meanwhile, the organic layer 135 may include a first organic layer 135a and a second organic layer 135b, and as the first organic layer 135a and the second organic layer 135b are spaced apart from each other, a trench 145 may be formed therebetween. Accordingly, the adhesive layer 165 may be formed to have a height difference due to a height of the organic layer, and may include a second region 142 on the trench 145.

Accordingly, in the sixth embodiment, during transfer of the semiconductor light-emitting device 150, bubbles may be gathered in the second region and may be discharged to an outer side of the substrate. Accordingly, in the sixth embodiment, a transfer process may be performed using a flat PDMS stamp, and a technical effect of implementing a higher-resolution display device than in a case of performing a transfer process using a stamp having protrusions can be provided. In addition, by performing the transfer process using a flat PDMS stamp, a technical effect of making a transfer rate uniform regardless of a central region and an outer region of the stamp can be provided.

Subsequently, referring to FIG. 12, semiconductor light-emitting devices 150a and 150b disposed on the adhesive layer 165 may be electrically connected to the panel wiring 125 through a side wiring 159. In addition, a planarization layer 185 may be disposed on the adhesive layer 165, and an upper wiring 158 may be disposed on the planarization layer 185 to be electrically connected to the semiconductor light-emitting devices 150a and 150b. In addition, the adhesive layer 165 may further include a light control material 190. The light control material 190 may include a light reflective material and a light scattering material. The light control material 190 may be positioned lower than the semiconductor light-emitting devices 150a and 150b. Accordingly, in the sixth embodiment, light emitted from the semiconductor light-emitting device and directed downward can be reflected and scattered, thereby improving light efficiency.

In addition, as the semiconductor light-emitting devices 150a and 150b are disposed on the organic layer 135 having a predetermined height, a distance from a thin film transistor of the substrate 110 increases, so that heat dissipation performance can be improved.

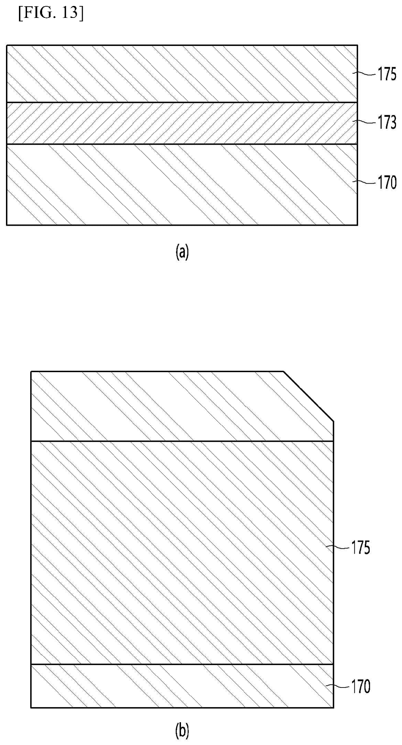

FIG. 13 is a conceptual view of a transfer donor for a semiconductor light-emitting device according to a seventh embodiment. Referring to FIG. 13(a), the donor according to the seventh embodiment may include a donor substrate 170, a donor adhesive layer 173 disposed on the donor substrate 170, and PDMS 175 disposed on the donor adhesive layer 173. The donor may be referred to as a PDMS stamp. Since bubbles generated during the transfer process in the first to sixth embodiments are trapped by a height difference of the organic layer and can be discharged to the outside, the PDMS 175 may have a flat structure. Accordingly, a high PPI display panel can be implemented, and when a stamp process is performed multiple times, a problem in which protrusions are not aligned in an overlapping region can be prevented, thereby providing a technical effect of implementing a large-area display panel.

Referring to FIG. 13(b), since the PDMS 175 has a flat structure, a problem in which a chip is positioned in a specific region of a protrusion can be prevented, thereby providing a technical effect of making a transfer rate uniform regardless of a central region and an outer region of the PDMS 175.

A transfer substrate for a semiconductor light-emitting device for a display pixel according to an embodiment can provide a technical effect of implementing a high PPI display panel.

For example, the embodiment can provide a separate region in which bubbles are trapped during a transfer process, and a flat stamp can be used in the transfer process, thereby enabling implementation of a high PPI display panel.

In addition, the embodiment can provide a technical effect of implementing a large-area display panel.

For example, the embodiment can provide a separate region in which bubbles are trapped during a transfer process, and a flat stamp can be used in the transfer process, thereby preventing transfer defects in a region where stamping overlaps, so that a large-area display panel can be implemented.

In addition, the embodiment can provide a technical effect of making a transfer rate uniform regardless of a region of a stamp.

For example, the embodiment can use a flat stamp without protrusions, thereby making the transfer rate uniform regardless of a central region and an outer region.

In addition, the embodiment can provide a technical effect of improving heat dissipation performance of a display device.

For example, in the embodiment, a semiconductor light-emitting device may be disposed on an organic layer, and a distance from a thin film transistor may increase, so that heat dissipation performance can be improved.

In addition, the embodiment can provide a technical effect of improving light efficiency of a display device.

For example, in the embodiment, a light control material may be added to an adhesive layer, and light efficiency of the display device can be improved through light reflection and scattering.

In addition, the embodiment can provide a technical effect of picking up a semiconductor light-emitting device assembled on an assembly substrate in a state in which a semiconductor light-emitting device is picked up by a stamp during a transfer process.

For example, in the embodiment, the semiconductor light-emitting device picked up by the stamp may be positioned on a first region, and the semiconductor light-emitting device assembled may be picked up by the stamp, thereby enabling multi pick-up and placement.

Although embodiments of the present invention have been described above with reference to the embodiments, those skilled in the art will readily understand that the present invention can be variously modified and changed without departing from the spirit and scope of the present invention defined in the appended claims.

### [Industrial Applicability]

The embodiment can be applied to a display device, but is not limited thereto. For example, the embodiment can be applied to a micro-LED display in which an LED, which is an inorganic light-emitting device, is used as a light-emitting pixel, but is not limited thereto.

## Claims

1. A transfer substrate for a semiconductor light-emitting device for a display pixel, comprising:
a substrate;
a plurality of assembly wirings disposed on the substrate;
an insulating layer disposed on the plurality of assembly wirings; and
an organic layer disposed on the insulating layer and including an assembly hole in which a semiconductor light-emitting device is assembled,
wherein the insulating layer comprises a first region,
and the first region is lower than the organic layer.

2. A transfer substrate for a semiconductor light-emitting device for a display pixel, comprising:
a substrate;
an insulating layer disposed on the substrate;
a plurality of organic layers disposed on the insulating layer to be spaced apart from each other;
a plurality of panel electrodes disposed on the organic layers; and
a second insulating layer disposed on the plurality of panel electrodes,
wherein a trench is formed between the plurality of organic layers.

3. The transfer substrate for a semiconductor light-emitting device for a display pixel according to claim 2,
wherein the insulating layer comprises a first region outside the organic layers,
and the first region has a lower height than the organic layers.

4. The transfer substrate for a semiconductor light-emitting device for a display pixel according to claim 2, wherein the panel electrodes comprise a first assembly hole in which a first semiconductor light-emitting device is assembled and a second assembly hole in which a second semiconductor light-emitting device is assembled,
and the second semiconductor light-emitting device is a redundant chip of the first semiconductor light-emitting device.

5. The transfer substrate for a semiconductor light-emitting device for a display pixel according to claim 3, wherein the organic layers are surrounded by the first region.

6. A display device comprising a semiconductor light-emitting device, comprising:
a substrate;
an insulating layer disposed on the substrate;
a plurality of organic layers disposed on the insulating layer to be spaced apart from each other;
panel wiring disposed on the organic layers;
an adhesive layer disposed on the panel wiring; and
a semiconductor light-emitting device disposed on the adhesive layer,
wherein the semiconductor light-emitting device is electrically connected to the panel wiring through a side wiring,
and the display device further comprises a trench between the plurality of organic layers.

7. The display device comprising a semiconductor light-emitting device according to claim 6, wherein the adhesive layer has different heights in a region vertically overlapping the organic layers and a region vertically overlapping the trench.

8. The display device comprising a semiconductor light-emitting device according to claim 6, further comprising a planarization layer covering the adhesive layer,
wherein the planarization layer is disposed to correspond to a shape of the adhesive layer.

9. The display device comprising a semiconductor light-emitting device according to claim 6, wherein the adhesive layer further comprises a light control material.

10. The display device comprising a semiconductor light-emitting device according to claim 6, further comprising a second region on the trench,
and wherein the second region is positioned lower than the semiconductor light-emitting device.
